# EUROPEAN PATENT APPLICATION

(11) **EP 4 838 186 A1**
(43) Date of publication of application: **11.11.2026**
(21) Application number: 26173671.4
(22) Date of filing: 21.04.2026
(51) Int. Cl.: G01H 1/00, G01K 1/14

(54) **SYSTEM FOR MONITORING OPERATING PARAMETERS FOR ROTATING COMPONENTS**

(30) Priority: 05.05.2025 US 202519198466
(71) Applicant: ABB Schweiz AG, 5400 Baden (CH)
(72) Inventor: MASK III, Robert J., Fort Smith, 72901 (US)
(74) Representative: Zimmermann & Partner Patentanwälte mbB

(57) **Abstract**

A system for monitoring at least one operating parameter for a rotating component is described. The system includes a sensor and a housing disposed around the rotating component. The sensor includes a probe, a handle opposing the probe, and a first engagement member disposed between the handle and the probe. The sensor is configured to detect data relating to the one or more operating parameters associated with the rotating component. The housing includes a channel. The channel includes corresponding engagement members configured to engage the first engagement member to affix the sensor to the housing such that the probe is disposed proximate the rotating component within the housing.

## Description

### TECHNICAL FIELD

The field of disclosure relates generally to a device and a system for monitoring operating parameters, and more particularly, to a device and a system for monitoring operating parameters for rotating components.

### BACKGROUND

In general, equipment with rotating components, such as motors, pumps, fans, and gearboxes, or the like, are prone to bearing failures. In some cases, these bearing failures can be caused by excessive vibrational and temperature variations associated with these rotating components.

Currently in the industry, existing solutions for monitoring parameters associated with rotating components are limited in their applications and abilities to effectively and efficiently monitor and maintain the equipment that comprise the monitored rotating components. Some existing solutions may require complex installation and calibration processes that may cause extended downtime of the equipment to complete the complex installation and calibration processes. Other existing solutions may require extensive modification and/or disassembly of the equipment for the solution to be properly installed in the equipment.

Based on the foregoing, a need exists for a device that is easy to install and proactively and reliably effectively monitors operating parameters for rotating components.

This background section is intended to introduce the reader to various aspects of art that may be related to various aspects of the present disclosure, which are described and/or claimed below. This discussion is believed to be helpful in providing the reader with supporting information to facilitate a better understanding of the various aspects of the present disclosure. Accordingly, it should be understood that these statements are to be read in this light, and not as admissions of prior art.

### BRIEF DESCRIPTION

In one aspect, a system for monitoring at least one operating parameter for a rotating component is described. The system comprises a sensor comprising a probe and a handle opposing the probe, and a first engagement member disposed between the handle and the probe. The sensor is configured to detect data relating to the one or more operating parameters associated with the rotating component. The system further comprises a housing disposed around the rotating component. The housing comprises a channel. The channel comprises corresponding engagement members configured to engage the first engagement member to affix the sensor to the housing such that the probe is disposed proximate the rotating component within the housing.

In another aspect, an electric motor is described. The electric motor comprises a rotor rotatably mounted within the electric motor. The rotor comprises a shaft extending towards a drive end of the electric motor. The electric motor further comprises a sensor comprising a probe, a handle opposing the probe, and a first engagement member disposed between the probe and the handle. The sensor is configured to detect data relating to one or more operating parameters associated with the rotor. The electric motor further comprises a motor housing enclosing the rotor. The motor housing comprises a channel. The channel comprises a corresponding engagement member configured to engage the first engagement member to affix the sensor to the motor housing such that the probe is disposed proximate the shaft within the motor housing.

In yet another aspect, a method of installation for a sensor configured to detect data relating to one or more operating parameters associated with a rotating component within a machine is described. The method comprises locating the sensor in a channel defined in a housing for the machine. The channel extends radially from the rotating component within the housing. The method further comprises engaging a first engagement member disposed on the sensor with a corresponding engagement member disposed on a wall of the channel.

Various refinements exist of the features noted in relation to the above-mentioned aspects. Further features may also be incorporated in the above-mentioned aspects as well. These refinements and additional features may exist individually or in any combination. For instance, various features discussed below in relation to any of the illustrated examples may be incorporated into any of the above-described aspects, alone or in any combination.

### BRIEF DESCRIPTION OF DRAWINGS

The following drawings form part of the present specification and are included to further demonstrate certain aspects of the present disclosure. The disclosure may be better understood by reference to one or more of these drawings in combination with the detailed description of specific embodiments presented herein.
Fig. 1 depicts a perspective view of a motor including a sensor for monitoring at least one operating parameter for a rotating component at each of a drive end and a non-drive end of the motor;
Fig. 2 depicts a partial cross-sectional cutaway perspective view of the drive end of the electric motor shown in Fig. 1;
Fig. 3 depicts a partial cross-sectional side view of the drive end of the electric motor shown in Fig. 1;
Fig. 4 depicts a perspective view of the non-drive end of the motor of Fig. 1 with a portion of a handle of a sensor disposed external to a housing of the motor;
Fig. 5 depicts a perspective view of the sensor for monitoring at least one operating parameter for a rotating component;
Fig. 6 depicts a perspective view of an alternative embodiment of the sensor for monitoring at least one operating parameter for a rotating component; and
Fig. 7 depicts a flowchart of an exemplary method of installation for a sensor configured to detect data relating to one or more operating parameters associated with a rotating component.

Corresponding reference characters indicate corresponding parts throughout the several views of the drawings. Although specific features of various examples may be shown in some drawings and not in others, this is for convenience only. Any feature of any drawing may be referenced or claimed in combination with any feature of any other drawing.

### DETAILED DESCRIPTION

The following detailed description and examples set forth preferred materials, components, and procedures used in accordance with the present disclosure. This description and these examples, however, are provided by way of illustration only, and nothing therein shall be deemed to be a limitation upon the overall scope of the present disclosure.

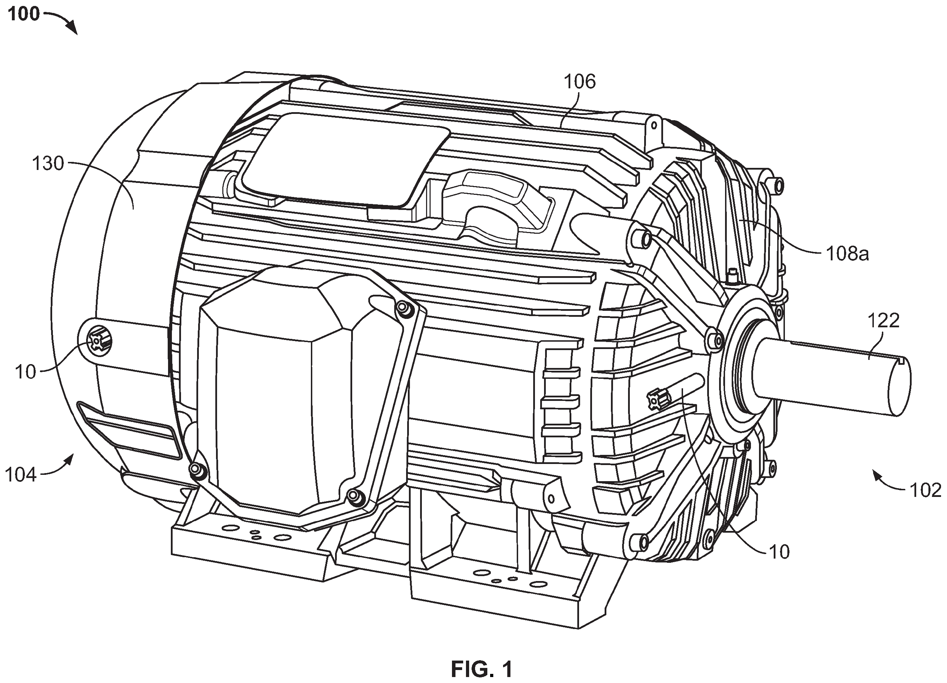

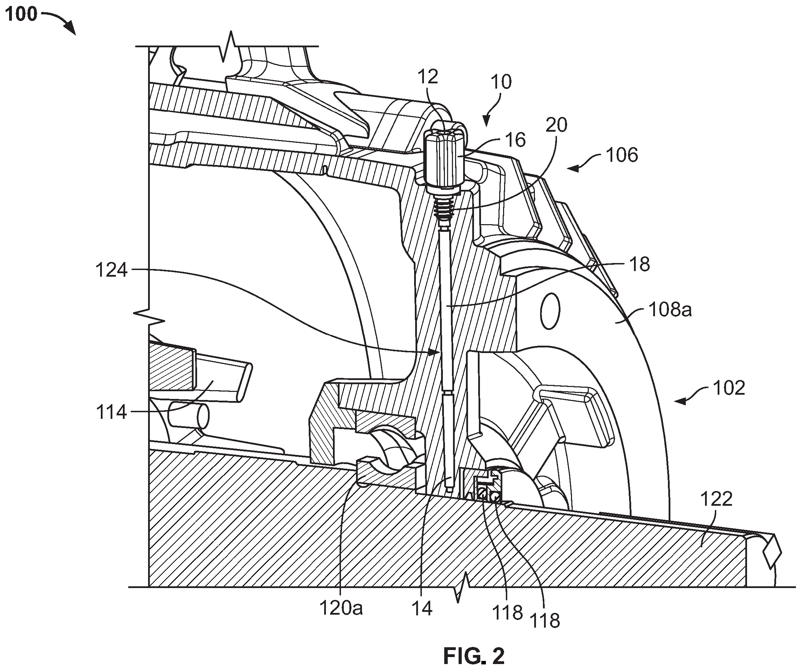

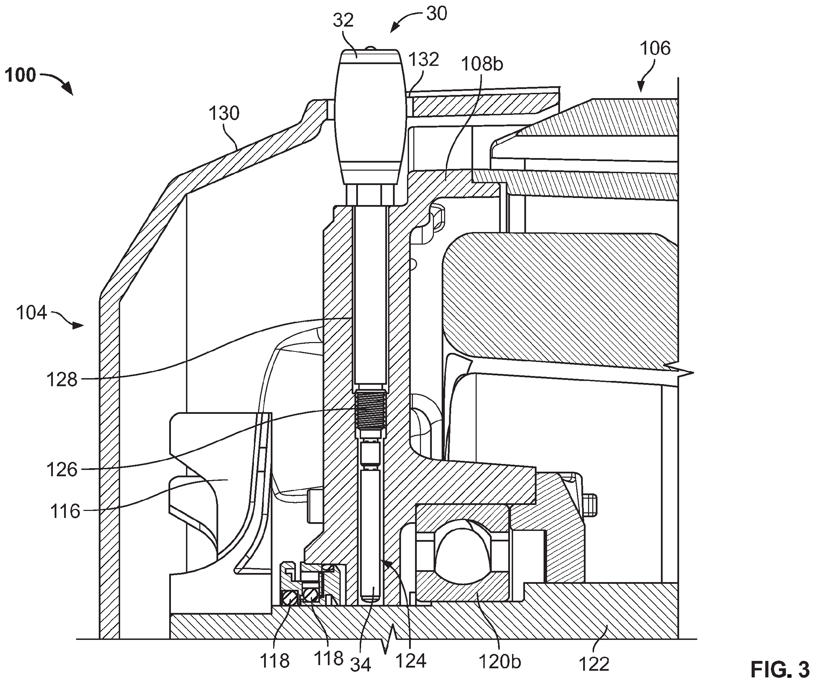

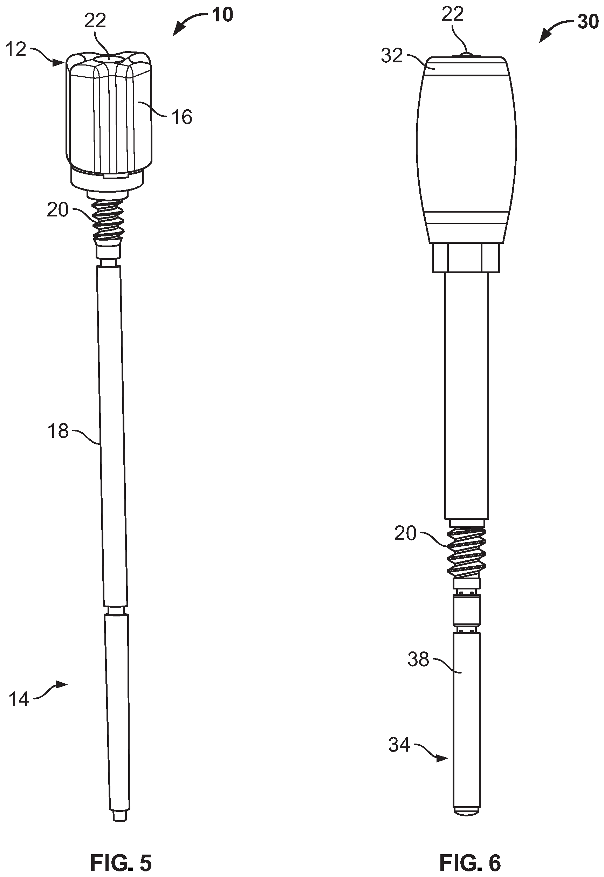

Fig. 1 illustrates a perspective view of a motor 100 including a sensor 10 for monitoring at least one operating parameter for a rotating component shown in Fig. 5 at each of a drive end 102 and a non-drive end 104 of the motor 100. Fig. 2 illustrates a partial cross-sectional cutaway perspective view of the drive end of the motor 100 shown in Fig. 1 that includes the sensor 10 shown in Fig. 5. The motor 100 may have a drive end 102 and a non-drive end 104 (shown in more detail in Fig. 3). The drive end 102 of the motor 100 is an end of the motor 100 where a shaft 122 of the rotor 114 is connected to a component that is driven by motor 100 (e.g., a powertrain or the like). The motor 100 includes a housing 106. The housing 106 may include a first end bell 108a disposed at a drive end 102 of the motor 100 and a second end bell 108b (shown in Fig. 3) disposed proximate the non-drive end 104 of the motor 100.

The housing 106 may enclose internal components of the motor 100. The housing 106 may enclose components such as a stator (not shown), a rotor 114, a fan 116 (shown in Fig. 3), at least one seal 118 (shown in Figs. 2 and 3), at least one bearing 120a, 120b, but the components enclosed by the housing 100 are not limited thereto. The stator may be configured to generate a rotating magnetic field that is used to produce rotational movement of the rotor 114. The rotor 114 may include a shaft 122 that extends through the housing 106 towards the drive end 102 of motor 100. The rotor 114 may be configured to convert electrical energy into mechanical energy during rotation of the rotor 114 produced by the rotating magnetic field generated by the stator. The fan 116 may be used to facilitate airflow to help cool the motor 100 and other components of the motor 100 and prevent overheating during operation of the motor 100. Each of the at least one seal 118 may be configured to act as a barrier to prevent the entry of debris into housing that may interfere with the operation of the motor 100 and/or rotation of the rotor 114 and shaft 122. Each of the at least one bearing 120a, 120b may be configured to facilitate smooth rotation of the shaft 122 and reduce friction and heat generation that may result from the rotation of the shaft 122. As shown in Fig. 2, bearing 120a may be disposed proximate to the drive end 102 of the motor 100. As shown in Fig. 3, bearing 120b may be disposed proximate to the non-drive end 104 of the motor 100.

The housing 106 also includes at least one channel 124. As shown in Figs. 2 and 3, each of the first end bell 108a and/or the second end bell 108b may include a channel 124. Each channel 124 may be disposed axially between a bearing 120a, 120b and a seal 118. For example, as shown in Fig. 2, channel 124 in end bell 108a is disposed axially between bearing 120a and seal 118 at a drive end 102 of the motor. Each channel 124 extends radially from the shaft 122 towards an outer periphery of the motor 100 and/or housing 106. Each channel 124 may be configured to receive one sensor 10, 30 to allow the sensor 10, 30 to receive a stimulus from the shaft 122 and/or a bearing 120a, 120b to detect the data relating to the one or more operating parameters associated with the shaft 122 and rotor 114. Although sensors for use with motor 100 are identified as 10, the sensors may comprise either sensor 10 of Fig. 5 or sensor 30 of Fig. 6. Both sensors will be described in greater detail below. As best shown in Fig. 3, each channel 124 may include at least one engagement member 126 formed on a wall 128 of the channel 124. The engagement member 126 may be disposed radially between the shaft 122 and the outer periphery of the housing 106. Each engagement member 126 may be configured to engage engagement member 20 to affix the sensor 10 to the housing 106 and prevent vibration of the sensor 10 that may cause inaccurate detection of data relating to the one or more operating parameters. Once inserted into the channel, the sensor 10, 30 may be oriented such that a probe 14, 34 of the sensor 10, 30 is disposed proximate to the shaft 122 and bearing 120a, 120b to allow the sensor to detect data relating to the one or more operating parameters for the shaft 122 and/or rotor 114, as described below.

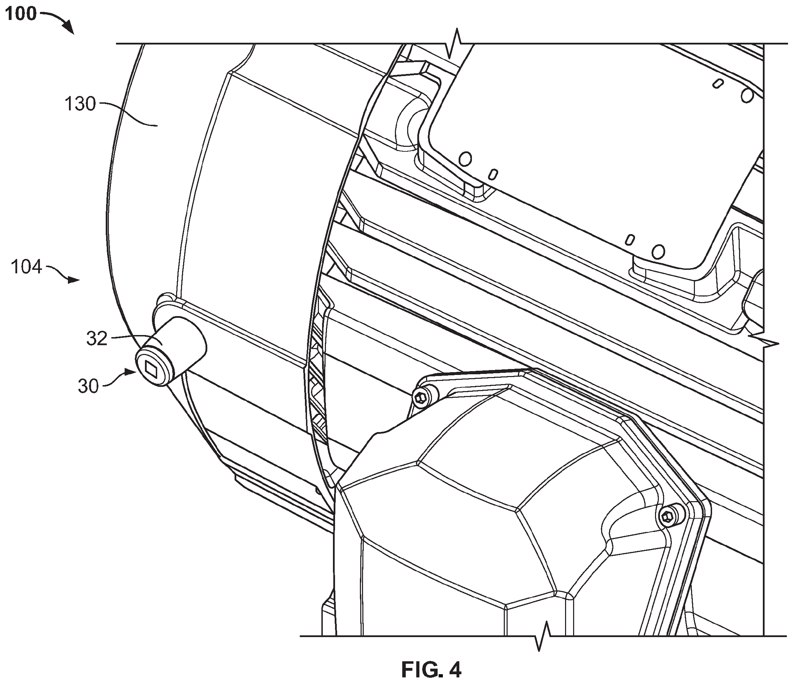

Fig. 3 illustrates a partial cross-sectional cutaway side view of the non-drive end of the electric motor 100 having the sensor 30 disposed at the non-drive end of the electric motor 100. Fig. 4 illustrates a perspective view of the non-drive end 104 of the motor 100 of Fig. 1 with a portion of a handle 32 of the sensor 30 shown in Fig. 6 disposed external to the housing 106 of the motor 100 when the sensor is positioned within the motor 100.

As shown in Figs. 2 and 3, when the sensor 10, 30 is positioned in a channel 124, in either the first end bell 108a and/or the second end bell 108b, and the engagement member 20 is engaged with engagement member 126, a portion of the handle 12, 32 of the sensor 10, 30 may be disposed external to the housing 106. The motor 100 may additionally have a fan cover 130 at a non-drive end 104 of the motor 100 to enclose the fan 116. The fan cover 130 may be attached to the housing 106 using fasteners, such as bolts, or the like. As best shown in Figs. 3 and 4, when the sensor 10, 30 is disposed proximate the non-drive end 104 of the motor 100, a portion of a handle 12, 32 of the sensor 10, 30 may be disposed external to each of the housing 106 and the fan cover 130 through an aperture 132 formed in the fan cover 130. Since the handle 12, 32 can be disposed external to the housing 106 and/or fan cover 130, the sensor 10, 30 may be installed and uninstalled without the need for extensive disassembly of the motor 100 thereby reducing labor costs and complexity associated with installation of the sensor 10, 30.

Fig. 5 illustrates a perspective view of the sensor 10 for monitoring at least one operating parameter for a rotating component. Sensor 10 includes a handle 12 mounted to a probe 14. Handle 12 may be used by an operator to install and/or uninstall the senor 10 in a housing (e.g., housing 106 of the like) of a piece of equipment (e.g., motor 100, pumps, fans, gearboxes, or the like) having a rotating component (e.g. rotor 114 or the like). The handle 12 can be made of at least one of plastic, metal, and rubber. As shown in Fig. 1, the handle 12 may include at least one ridge 16. The at least one ridge 16 may allow an operator to more effectively grasp the handle 12 for installation and removal of the sensor 10 into and/or out of the housing of a piece of equipment.

The probe 14 may have an elongated tubular body 18. The elongated tubular body 18 may allow the probe 14 to extend a desired length to allow the sensor 10 to accurately detect data relating to the one or more operating parameters associated with a rotating component (e.g., rotor 114 or the like) within a piece of equipment (e.g., motor 100 or the like). The sensor 10 may include at least one sensing element (not shown) that is configured to detect the data relating to the one or more operating parameters associated with the rotating component. The data relating to the one or more operating parameters that is detected may be used by an operator to identify any potential issues associated with the rotating component and/or equipment having the rotating component and quickly perform any necessary maintenance before any extended downtime resulting from such issues. The at least one sensing element may be disposed within the elongated tubular body 18. In an embodiment, the one or more operating parameters may be a vibration, a temperature, and/or a voltage associated with the rotating component, but is not limited thereto. The at least one sensing element may be configured to receive a stimulus from the rotating component to detect the data relating to the one or more operating parameters associated with the rotating component. For example, the at least one sensing element may include a temperature-sensitive resistor, thermocouples, or the like to allow the sensor 10 to detect the data relating to temperature associated with the rotating component. The at least one sensing element may also include a piezoelectric crystal (not shown) or the like to allow the sensor 10 to detect the data relating to vibrations associated with the rotating component. The at least one sensing element may also include a thin layer of semiconductor material (not shown) to allow the sensor 10 to detect the data relating to a voltage associated with the rotating component. The semiconductor material may generate a Hall voltage when a current flows through the semiconductor material in the presence of a magnetic field. Some exemplary semiconductor material may include silicon (Si), gallium arsenide (GaAs), or indium antimonide (InSb), or the like. The sensor 10 may also include a transducer (not shown). The transducer may receive a signal from the at least one sensing element and convert the signal received from the at least one sensing element into a measurable electrical signal.

The sensor 10 includes at least one engagement member 20. The engagement member 20 is disposed between the handle 12 and the probe 14. The engagement member 20 may be configured to engage a housing engagement member (e.g., housing engagement member 126, or the like) to form a mechanical engagement between the sensor 10 and a housing to affix the sensor 10 and prevent undesired vibration of the sensor 10 that may cause inaccurate detection of data relating to the one or more operating parameters. As shown in Fig. 1, the engagement member 20 may be threads disposed circumferentially around a portion of the sensor 10 between the handle 12 and the probe 14. Alternatively, the engagement member 20 may be an engagement tooth, friction pads, or any other member that can be used to create a mechanical engagement between the sensor 10 and a housing and prevent undesired vibration of the sensor 10. The engagement member 20 may allow the sensor 10 to be quickly, easily, and safely installed into a housing for a piece of equipment to reduce labor costs and avoid complex installation of the sensor 10. The engagement member 20 may also allow the sensor 10 to be retrofit into existing pieces of equipment, such as existing motors, fans, or the like, without the need for extensive disassembly of these existing pieces of equipment.

In some embodiments, the sensor 10 may include a wireless communication module 22. The wireless communication module 22 may be configured to transmit a signal related to the sensed data relating to the one or more operating parameters based on the electrical signal from the transducer. In some exemplary embodiment, the wireless communication module 22 may use at least one of low-power, wide-area network (LoRaWAN), wireless fidelity (Wi-Fi), cellular technology, or the like. The wireless communication module 22 may be positioned within the handle 12 to protect the wireless communication module 22 from damage during use of the sensor 10.

Fig. 6 illustrates a perspective view of an alternative embodiment of a sensor 20 for monitoring at least one operating parameter for a rotating component. The sensor 20 may include features from the first embodiment of the sensor 10. For example, as shown in Fig. 6, the sensor includes engagement member 16 disposed between a handle 32 and a probe 34 and wireless communication module 22, at least one sensing element (not shown), but is not limited thereto. The sensor 20 includes handle 32. The handle 32 may be bulbous shape to allow a user to grasp the handle 32 for installation and removal of the sensor 20, as described herein. As shown in Fig. 6, the tubular body 38 for the probe 34 is shorter than tubular body 18 for probe 14. However, the length of the sensor 30 may be substantially similar to the length of the sensor 10.

Each sensor 10, 30 may be configured to detect baseline data for the data relating to the one or more operating parameters associated with the rotating component. Continuing the example described above, sensors 10, 30 may be configured to detect a baseline temperature, a baseline amount of vibration, and/or a baseline voltage induced within the rotor 114 during rotation of the rotor 114 and shaft 122 for operation of the motor 100. The baseline data may be a typical range associated with the operating parameters during operation of the motor 100 and/or rotation of the rotor 114 and shaft 122.

Each sensor 10, 30 may be configured to detect a variation in the data relating to the one or more operating parameters associated with the rotating component. Continuing the example described above, sensors 10, 30 may be configured to detect a variation in the temperature, a variation in the amount of vibration, and/or a variation in the voltage induced within the rotor 114 during rotation of the rotor 114 and shaft 122 for operation of the motor 100. The variation may be a deviation from the typical range associated with the operating parameters during operation of the motor 100 and/or rotation of the shaft 122. The variation may be a deviation that is greater than a threshold deviation from the typical range associated with the operation of the motor and/or rotation of the rotor 114 and shaft 122. For example, the threshold deviation may be a 5% difference, a 10% difference, or the like.

The wireless communication module 22 of sensors 10, 30 may be configured to transmit a signal when the sensor 10, 30 detects the variation of the data related to the one or more operating parameters associated with the rotating component. Continuing the example described above, the wireless communication module 22 of the sensor 10, 30 may be configured to transmit a signal when the sensor 10, 30 detects a variation in the temperature, a variation in the amount of vibration, and/or a variation in the voltage level during operation of the motor 100 and/or rotation of the rotor 114 and shaft 122. The wireless communication module 22 may enable remote monitoring of the motor 100 to allow real-time data about the motor 100 and/or rotor 114 to be detected for early identification of potential issues with the motor 100 and/or rotor 114.

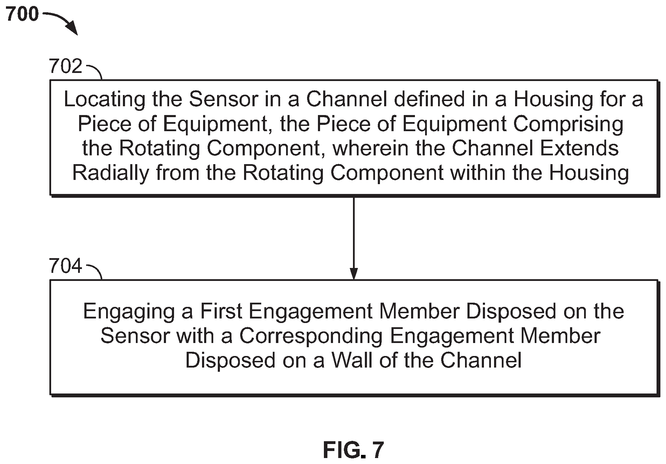

Fig. 7 illustrates a flowchart of an exemplary method 700 of installation for a sensor 10, 30 configured to detect data relating to one or more operating parameters associated with a rotating component (e.g., shaft 114, rotor, or the like) within a machine (e.g., motor 100, or the like).

At 702, the method 700 comprises locating the sensor 10, 30 in a channel 124 defined in a housing for the machine, wherein the channel 124 extends radially from the rotating component within the housing 106. Locating the sensor 10, 30 may include inserting the sensor 10, 30 into the channel 124 such that the sensor 10, 30 also extends radially from the rotating component and at least a portion of the sensor 10, 30 is disposed external to the housing 106.

At 704, the method 700 comprises engaging an engagement member 20 disposed on the sensor 10 with a corresponding engagement member 126 disposed on a wall 128 of the channel 124. Each of the first engagement member 20 and engage member 124 may be threads to affix the sensor 10, 30 to prevent vibration of the sensor 10 that may cause inaccurate detection of data relating to the one or more operating parameters.

As used herein, an element or step recited in the singular and proceeded with the word "a" or "an" should be understood as not excluding plural elements or steps unless such exclusion is explicitly recited. Furthermore, references to "one embodiment" of the disclosure or an "exemplary" or "example" embodiment are not intended to be interpreted as excluding the existence of additional embodiments that also incorporate the recited features. Likewise, limitations associated with "one embodiment" or "an embodiment" should not be interpreted as limiting to all embodiments unless explicitly recited.

Disjunctive language such as the phrase "at least one of X, Y, or Z," unless specifically stated otherwise, is generally intended, within the context presented, to disclose that an item, term, etc. may be either X, Y, or Z, or any combination thereof (e.g., X, Y, and/or Z). Likewise, conjunctive language such as the phrase "at least one of X, Y, and Z," unless specifically stated otherwise, is generally intended, within the context presented, to disclose at least one of X, at least one of Y, and at least one of Z.

The disclosed systems and methods are not limited to the specific embodiments described herein. Rather, components of the systems or steps of the methods may be utilized independently and separately from other described components or steps.

This written description uses examples to disclose various embodiments, which include the best mode, to enable any person skilled in the art to practice those embodiments, including making and using any devices or systems and performing any incorporated methods. The patentable scope is defined by the claims and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A system for monitoring at least one operating parameter for a rotating component, the system comprising:
a sensor comprising a probe, a handle opposing the probe, and a first engagement member disposed between the handle and the probe, the sensor configured to detect data relating to the one or more operating parameters associated with the rotating component; and
a housing disposed around the rotating component, the housing comprising a channel, the channel comprising corresponding engagement members configured to engage the first engagement member to affix the sensor to the housing such that the probe is disposed proximate the rotating component within the housing.

2. The system for monitoring vibration and temperature of claim 1, wherein the sensor extends radially from the rotating component when positioned within the channel.

3. The system for monitoring vibration and temperature of claim 1, wherein the handle is disposed external to the housing when the first engagement member is engaged with the corresponding engagement member.

4. The system for monitoring operating parameters of claim 1, wherein the one or more operating parameters comprise at least one of a vibration, a temperature, and a voltage associated with the rotating component.

5. The system for monitoring vibration and temperature of claim 4, wherein the sensor is further configured to detect a baseline for the data related to the voltage associated with the rotating component.

6. The system for monitoring vibration and temperature of claim 5, wherein the sensor is further configured to detect a variation of the data related to the voltage associated with the rotating component, particularly wherein the sensor further comprises a wireless communication module configured to transmit a signal when the sensor detects the variation of the data related to the voltage associated with the rotating component.

7. The system for monitoring vibration and temperature of claim 4, wherein the sensor is configured to detect a baseline for the data related to the vibration associated with the rotating component.

8. The system for monitoring vibration and temperature of claim 7, wherein the sensor is further configured to detect a variation of the data related to the vibration associated with the rotating component, particularly wherein the sensor further comprises a wireless communication module configured to transmit a signal when the sensor detects the variation of the data related to the vibration associated with the rotating component.

9. The system for monitoring vibration and temperature of claim 1, wherein the sensor is disposed proximate a drive end of the rotating component.

10. An electric motor, comprising:
a rotor rotatably mounted within the electric motor, the rotor comprising a shaft extending towards a drive end of the electric motor;
a sensor comprising a probe, a handle opposing the probe, and a first engagement member disposed between the probe and the handle, the sensor configured to detect data relating to one or more operating parameters associated with the rotor; and
a motor housing disposed around the rotor, the motor housing comprising a channel, the channel comprising a corresponding engagement member configured to engage the first engagement member to affix the sensor to the motor housing such that the probe is disposed proximate the shaft within the motor housing.

11. The electric motor of claim 10, wherein the sensor extends radially from the shaft of the rotor when positioned within the channel.

12. The electric motor of claim 11, wherein the motor housing comprises an end bell disposed around the shaft and the end bell comprises the channel, particularly wherein the first engagement member comprises threads and the corresponding engagement member comprises corresponding threads configured to affix the sensor to the end bell, more particularly wherein the handle is disposed external to the end bell when the sensor is affixed to the end bell.

13. The electric motor of claim 10, wherein the sensor is further configured to detect a baseline for the data related to a voltage associated with the rotor, particularly wherein the sensor is further configured to detect a variation of the data related to the voltage associated with the rotor.

14. The electric motor of claim 10, wherein the sensor is disposed proximate a drive end of the electric motor.

15. A method of installation for a sensor configured to detect data relating to one or more operating parameters associated with a rotating component within a machine, the method comprising:
locating the sensor in a channel defined in a housing for the machine, wherein the channel extends radially from the rotating component within the housing; and
engaging a first engagement member disposed on the sensor with a corresponding engagement member disposed on a wall of the channel.
